# DEMANDE DE BREVET EUROPEEN

(11) **EP 1 835 534 A1**
(43) Date de publication de la demande: **19.09.2007**
(21) Numéro de dépôt: 07103778.2
(22) Date de dépôt: 08.03.2007
(51) Int. Cl.: H01L 21/762

(54) **Procédé de fabrication de film mince**

(30) Priorité: 13.03.2006 FR 0650832
(71) Demandeur: S.O.I.Tec Silicon on Insulator Technologies, 38190 Bernin (FR)
(72) Inventeur: Tauzin, Aurélie, 38120 Saint Egreve (FR); Personnic, Sébastien, 38000 Grenoble (FR); Laugier, Frédéric, 38120 Saint-Egrève (FR)
(74) Mandataire: Desormiere, Pierre-Louis

(57) **Abrégé**

Procédé de fabrication d'un film mince comprenant:
a) une étape (S1) d'implantation par bombardement d'une face d'un substrat en matériau semi-conducteur au moyen d'ions pour former, à une profondeur déterminée dans le substrat, une couche de concentration desdits ions implantés, ladite couche de concentration délimitant, dans la partie supérieure du substrat, un film mince,
b) une étape (S2) de mise en contact intime de la face du substrat avec un raidisseur, et
c) une étape (S4) de détachement du film mince en contact avec le raidisseur par clivage au niveau de la couche de concentration des ions.

Le procédé comprend en outre, après l'étape a) d'implantation et avant l'étape c) de détachement, une étape (S3) de traitement thermique de piégeage des contaminants qui ne provoque pas le clivage du substrat au niveau de la couche de concentration d'ions, et, après l'étape c), une étape de retrait de la zone perturbée par le piégeage des contaminants et par l'étape c) de détachement.

## Description

La présente invention concerne un procédé de fabrication de film mince de matériau semi-conducteur faisant intervenir la technologie Smart Cut™. Un exemple de mise en oeuvre de la technologie Smart Cut™ est notamment décrit dans le document US 5 374 564 ou dans l'article de A.J. Auberton-Hervé et al. intitulé "Why can Smart-Cut Change the future of microelectronics ?", Int. Journal of High Speed Electronics and Systems, Vol.10, No1, 2000, p.131-146. Cette technologie met en oeuvre les étapes suivantes:
a) Bombardement d'une face d'un substrat (par exemple en silicium) avec des ions légers de type hydrogène ou gaz rares (par exemple hélium) pour implanter ces ions en concentration suffisante dans le substrat et créer une couche de microcavités fragilisantes,
b) mise en contact intime de cette face du substrat avec un raidisseur ou substrat receveur, et
c) fracture/clivage au niveau de la couche de microcavités par application d'un traitement thermique et/ou d'une contrainte mécanique de détachement comme par exemple l'insertion d'une lame au niveau de la couche de microcavités et/ou application d'efforts de traction et/ou de flexion et/ou de cisaillement, et/ou encore l'application d'ultrasons ou de micro-ondes de puissance et de fréquence adaptées.

Ce procédé permet d'obtenir, par détachement d'une portion du substrat implanté, un film mince d'une épaisseur homogène correspondant sensiblement à la distance entre la face du substrat bombardée et la couche de microcavités formée par l'implantation. En comparaison avec d'autres procédés connus de fabrication de films minces comme par exemple le procédé dit "SIMOX" (notamment décrit dans le document "SIMOX SOI for Integrated Circuit Fabrication", Hon Wai Lam, IEEE Circuits and Devices Magazine, Juillet 1987) ou les procédés d'amincissement d'une plaque ("wafer") par abrasion mécano-chimique ou chimique, ce procédé ne nécessite pas de très fortes doses d'implantation ni de barrière d'arrêt de gravure.

Cependant, avec ce procédé, le film mince transféré contient en volume des impuretés contaminantes de métaux simples (Al), métaux de transition (Ti, Cr, Fe, Co, Ni, Cu, Zn, etc.), métaux alcalins (Li, Na, K, etc.), métaux alcalino-terreux (Mg, Ca, Ba, etc.), halogène (F, Br, Cl), métalloïde (As), ou encore de type contaminants organiques (C, N, O). Ces impuretés correspondent aux impuretés présentes dans le substrat de départ et/ou aux impuretés introduites par le procédé utilisé. Par exemple, la présence d'impuretés de type métaux de transition peut entraîner des variations importantes des propriétés électriques dans le film mince transféré.

### Résumé de l'invention

L'invention a pour but de remédier aux inconvénients précités et de proposer une solution qui permet la réalisation de films minces par un procédé comprenant notamment une étape d'implantation d'ions légers pour créer une couche de microcavités correspondant à une zone de fragilisation au niveau de laquelle peut être réalisé un clivage du substrat (technologie Smart Cut™), et ce tout en réduisant la concentration volumique des impuretés présentes dans le film détaché.

Ce but est atteint avec un procédé de fabrication d'un film mince comprenant:
a) au moins une étape d'implantation par bombardement d'une face d'un substrat en matériau semi-conducteur au moyen d'ions légers de type hydrogène ou hélium, seuls ou en combinaison avec d'autres espèces (par exemple co-implantation bore-hydrogène) pour former, à une profondeur déterminée dans le substrat, une couche de concentration desdits ions implantés, ladite couche de concentration délimitant, dans la partie supérieure du substrat, un film mince,
b) une étape de mise en contact intime de la face du substrat avec un raidisseur,
c) une étape de détachement du film mince en contact avec le raidisseur par clivage au niveau de la couche de concentration des ions,
procédé dans lequel, après l'étape a) d'implantation et avant l'étape c) de détachement, on réalise un traitement thermique pour piéger des contaminants dans la couche de concentration d'ions implantés, ledit traitement ne provoquant pas le clivage du substrat au niveau de la couche de concentration d'ions implantés. Après l'étape c), la zone perturbée par le piégeage des contaminants et par l'étape de détachement est éliminée.

L'étape de traitement thermique réalisée après l'implantation permet, d'une part, le développement/formation de microcavités au niveau de la couche de concentration d'ions implantés qui forment des cavités de piégeage et, d'autre part, la diffusion et le piégeage des contaminants dans ces cavités. La partie du substrat située au-dessus des microcavités de piégeage, qui correspond au film mince à transférer, présente alors une concentration réduite en espèces contaminantes sauf en surface au niveau de la zone perturbée subsistant au dessus du film mince après le clivage. Une étape d'élimination de cette zone perturbée est alors réalisée, ce qui permet de retirer du film mince transféré les dernières traces subsistantes de contaminants. Cette étape d'élimination de la zone perturbée est réalisée au moyen de traitements ne faisant pas intervenir de hautes températures afin d'éviter une rediffusion des contaminants piégés au niveau de la zone perturbée dans le film mince. Cette étape peut notamment être réalisée au moyen d'un polissage mécano-chimique et/ou d'une attaque chimique sélective appropriée permettant d'éliminer la zone en surface perturbée et contaminée par le piégeage des contaminants et par l'étape de détachement.

Les traitements thermiques tels que les recuits à haute température habituellement mis en oeuvre après une fracture, par exemple suivant la technologie Smart Cut™, peuvent être ensuite effectués sans risque de rediffusion des contaminants dans le film mince transféré puisque les traces de contaminants ont été éliminées de ce dernier.

Le procédé de l'invention permet, par conséquent, de fabriquer des films minces ayant une concentration en espèces contaminantes réduite. Grâce au piégeage des contaminants et à l'élimination des contaminants piégés du film transféré, il est possible de réaliser des films minces à partir de substrats présentant un taux de contamination plus important que celui habituellement requis lors de ce type fabrication de film mince (notamment par la technologie Smart Cut™), ces substrats étant, par conséquent, moins coûteux.

Le substrat peut être un substrat de silicium, ou de germanium, ou de silicium-germanium, ou de nitrure de gallium, ou d'arséniure de gallium, ou de carbure de silicium.

Selon un aspect de l'invention, le procédé comprend en outre une étape d'implantation supplémentaire consistant à bombarder la face du substrat dans des conditions d'implantation différentes de celles utilisées pour l'implantation de l'étape a), ladite étape d'implantation supplémentaire étant notamment réalisée à une énergie d'implantation supérieure à celle de l'étape a) pour créer une couche de concentration supplémentaire d'ions à une profondeur plus importante que la couche de concentration d'ions crée lors de l'étape a).

Dans ce cas, les cavités de piégeage sont développées/formées dans la couche de concentration d'ions supplémentaires qui est située en dessous de la couche de concentration d'ions destinée à former un plan de fragilisation le long duquel le film mince doit être détaché. Les contaminants sont alors piégés dans une zone située en dessous de la zone de détachement du film mince et sont confinés dans la masse du substrat qui ne fait pas partie du film mince à transférer.

L'étape d'implantation supplémentaire peut être réalisée avec des ions de gaz hélium.

Dans l'étape c), le détachement du film mince (fracture du substrat) peut être provoqué par une contrainte de détachement appliquée au niveau de la couche de concentration des ions implantés. La contrainte de détachement peut consister en l'application d'un traitement thermique (un recuit réalisé à une température supérieure à la température du traitement thermique de piégeage) et/ou d'une contrainte mécanique de détachement comme par exemple l'insertion d'une lame au niveau de la couche de concentration des ions implantés et/ou application d'efforts de traction et/ou de flexion et/ou de cisaillement et/ou encore l'application d'ultrasons ou de micro-ondes de puissance et de fréquence adaptées.

Le procédé peut comprendre en outre, après l'élimination de la zone perturbée au dessus du film mince transféré, une étape de recuit à environ 1000°C dudit film sur le raidisseur.

### Brève description des figures

- les figures 1A à 1E sont des vues schématiques en coupe montrant la réalisation d'un film mince de Si conformément à un mode de mise en oeuvre de l'invention,
- la figure 2 est un organigramme des étapes mises en oeuvre dans les figures 1A à 1E,
- les figures 3A à 3F sont des vues schématiques en coupe montrant la réalisation d'un film mince de Si conformément à un autre mode de mise en oeuvre de l'invention,
- la figure 4 est un organigramme des étapes mises en oeuvre dans les figures 3A à 3F,
- la figure 5 montre la concentration en fluor dans un substrat de Si en fonction de la durée du traitement thermique de piégeage des contaminants de l'invention,
- la figure 6 montre la concentration en fluor dans un substrat de Si en fonction de la température du traitement thermique de piégeage des contaminants de l'invention,
- la figure 7 montre l'influence du traitement thermique de piégeage de l'invention sur des contaminants de nature différente.

### Exposé détaillé de modes de réalisation de l'invention

La méthode de la présente invention s'applique d'une manière générale à la fabrication de films minces de matériaux semi-conducteurs à partir de tout type de substrat compatible avec la technologie Smart Cut™. De tels substrats sont notamment des substrats en silicium (Si), germanium (Ge), silicium-germanium (SiGe), nitrure de gallium (GaN), arséniure de gallium (GaAs), carbure de silicium (SiC), etc.

L'invention propose d'appliquer, lors de la fabrication d'un film mince selon la technologie Smart Cut™, un traitement thermique supplémentaire après l'étape d'implantation et avant l'étape de détachement qui permet de former des microcavités au niveau de la couche implantée dans lesquelles sont piégés les contaminants présents dans le substrat de départ et/ou introduits lors des étapes d'implantation et de collage. Ces microcavités présentent sur leurs parois internes des liaisons chimiques incomplètes qui permettent de piéger les atomes des espèces contaminantes.

Ce traitement thermique supplémentaire doit être réalisé à une température suffisamment élevée pour permettre la diffusion des espèces contaminantes dans les microcavités de piégeage mais sans dépasser la température limite qui provoque la fracture du substrat au niveau de la couche d'implantation par effet de réarrangement cristallin dans le substrat et de pression dans les microcavités. Les microcavités de piégeage peuvent être développées et/ou formées directement dans la couche d'implantation destinée à provoquer le clivage ("splitting") du substrat (technologie Smart Cut™) ou dans une couche d'implantation séparée formée en dessous de cette couche.

Les documents "Comparison of Cu gettering to H+ and He+ implantation-induced cavities in separation-by-implantation-of-oxygen wafers" de Zhang M. et al, Journal of Applied Physics, Vol. 85, N° 1, January 1, 1999, et "Gettering of platinium and silver to cavities formed by hydrogen implantation in silicon" de Kinomura A. et al, Nuclear Instruments and Methods in Physics Research B 127/128 (1997) 297-300, divulguent la formation de cavités de piégeage par implantation H⁺ ou He suivie d'un traitement thermique. Toutefois, les cavités de piégeage ne sont pas utilisées pour la fracture/clivage du substrat. Au contraire, dans ces deux documents, les contaminants sont introduits volontairement par implantation ionique et sont conservés dans le substrat.

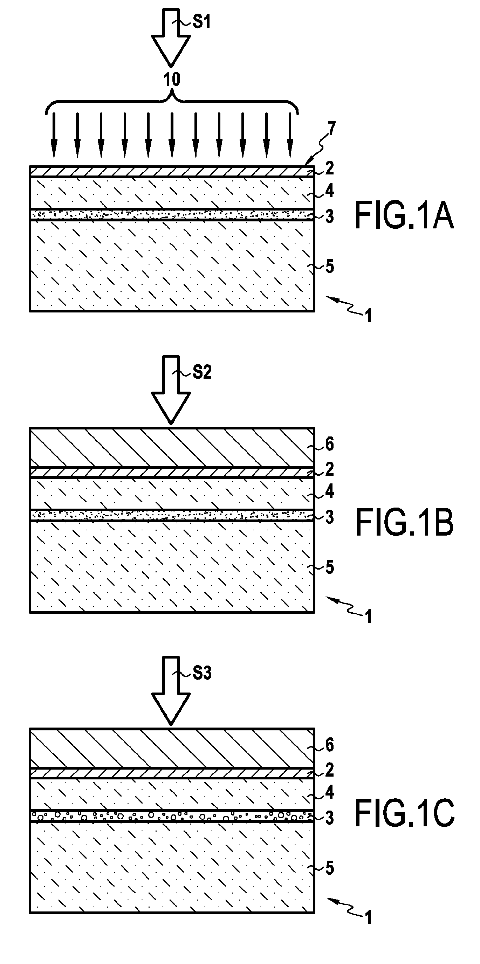

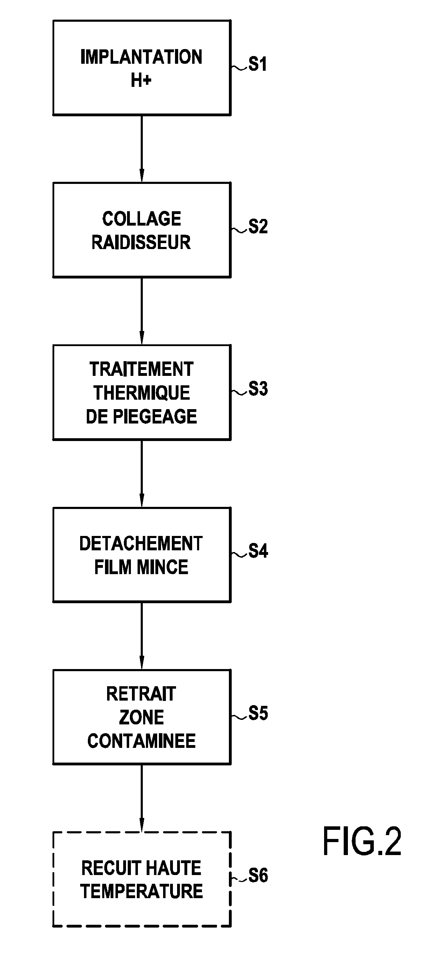

On décrit, en référence aux figures 1A à 1E et 2, un procédé de réalisation d'un film mince conformément à un mode de réalisation de l'invention.

Dans ce mode de réalisation, le substrat de départ ou substrat donneur 1 est constitué d'une plaque (ou "wafer") de silicium monocristallin recouvert d'une couche d'oxyde de silicium (SiO₂) 2 obtenue par oxydation thermique et présentant une épaisseur d'environ 1450 Å.

Dans une première étape d'implantation (étape S1), le substrat 1 est soumis à un bombardement ionique 10 d'ions hydrogène H⁺ à travers la face plane 7 du substrat comportant la couche (SiO₂) 2. L'implantation des ions H⁺ est réalisée avec une énergie d'implantation d'environ 37 keV et une dose d'implantation d'environ 5,75.10¹⁶ atomes/cm². Ces conditions d'implantation permettent de créer, à une profondeur déterminée dans le substrat 1, une couche de concentration d'ions 3 parallèle à la face 7 du substrat délimitant, d'une part, un film mince 4 dans la région supérieure du substrat 1 et, d'autre part, une portion 5 dans la région inférieure du substrat correspondant au reste du substrat 1 (figure 1A).

La dose d'implantation est choisie de manière à ce que la concentration des ions H⁺ dans la couche 3 soit suffisante pour créer une couche de microcavités directement après implantation ou lors d'une étape de traitement thermique ultérieure. On note toutefois que des microcavités peuvent déjà se former lors de l'implantation. La profondeur de pénétration des ions H⁺ dans le substrat est déterminée principalement par le niveau d'énergie d'implantation. Dans l'exemple décrit ici, l'implantation est réalisée avec une énergie d'implantation d'environ 37 keV qui permet de former la couche de concentration d'ions H⁺ 3 à environ 300 nm sous la face 7 du substrat 1 bombardée.

Le substrat de départ 1 implanté est ensuite collé, par exemple par adhésion moléculaire, sur un raidisseur 6, par exemple une plaque de silicium (étape S2, figure 1B). Le substrat de départ 1 contient des impuretés résiduelles (comme du fluor F, du carbone C, etc.). En outre, les étapes d'oxydation (formation couche de SiO₂), d'implantation ionique et de collage peuvent augmenter en volume la contamination en impuretés du substrat de départ 1.

Conformément à l'invention, on réalise une étape de traitement thermique adaptée permettant le développement et/ou la formation de microcavités au niveau de la couche de concentration d'ions H⁺ 3 et la diffusion des diverses espèces contaminantes jusqu'aux microcavités où elles sont piégées (étape S3, figure 1C). Dans ce mode de réalisation, les microcavités constituent non seulement des pièges pour les espèces contaminantes diffusées mais aussi un plan de fragilisation permettant une fracture ultérieure du substrat par application de contraintes mécaniques.

L'étape de traitement thermique peut être, par exemple, un recuit à 350 °C sur une durée de 18 heures. Un tel recuit permet d'augmenter localement la quantité en ions fluor au niveau de la couche 3 d'un facteur 50 et, par conséquent, de diminuer la concentration en ions fluor dans le reste du substrat et en particulier dans la portion correspondant au film mince 4 à détacher. Le recuit à 350 °C pendant 18 heures permet également de diviser par deux la concentration en impuretés de carbone dans le film mince 4. Enfin, ce recuit (350 °C-18 h) entraîne la formation de microcavités qui fragilisent localement le substrat et lui confère à cet endroit (i.e. au niveau de la couche 3) des caractéristiques de densité, dimensions, répartition, morphologie, etc., compatible avec une fracture.

Dans l'exemple décrit ici, l'étape de traitement thermique est réalisée après l'étape de collage sur le raidisseur (étape S2). Toutefois, cette étape de traitement thermique peut être réalisée avant l'étape de collage sur le raidisseur 6.

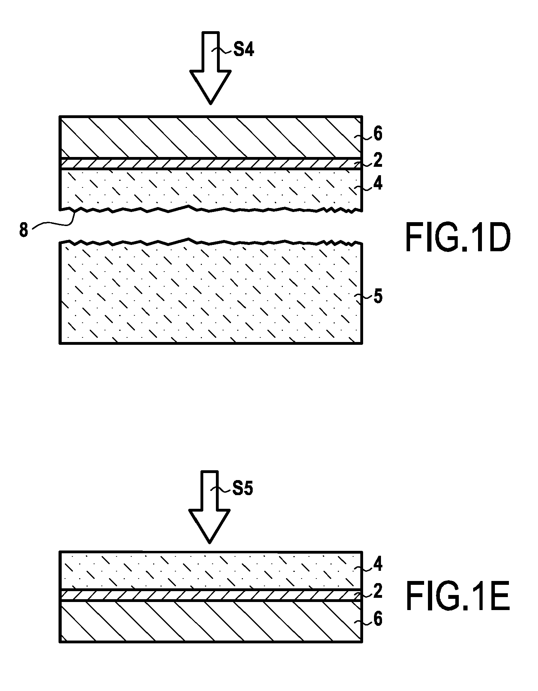

Après l'étape de traitement thermique, on procède au détachement du film mince 4 du substrat 1 par clivage (étape S4, figure 1D). Cette étape est réalisée, par exemple, par application de contraintes mécaniques, comme par exemple par insertion d'une lame au niveau de la zone des microcavités entraînant la propagation d'une fracture le long de cette zone.

Le film mince 4 transféré sur le raidisseur 6 contient peu de contaminants dans son volume sauf au niveau de sa surface fracturée 8 qui concentre, après l'étape de traitement thermique, les espèces contaminantes qui ont diffusées et qui ont été piégées dans les microcavités.

Une étape de polissage classique (polissage mécano-chimique) est alors réalisée pour éliminer la zone contaminée et perturbée de la surface 8 et pour réduire son niveau de rugosité (étape S5, figure 1E). L'épaisseur retirée par le polissage est de l'ordre de 1500 Å. La zone contaminée/perturbée peut être également éliminée par une attaque (gravure) chimique sélective éventuellement suivie d'un polissage pour améliorer la rugosité de surface.

Un traitement thermique final à haute température (1100°C) peut être ensuite appliqué pour consolider la structure et guérir les éventuels défauts présents dans le film transféré (étape S6).

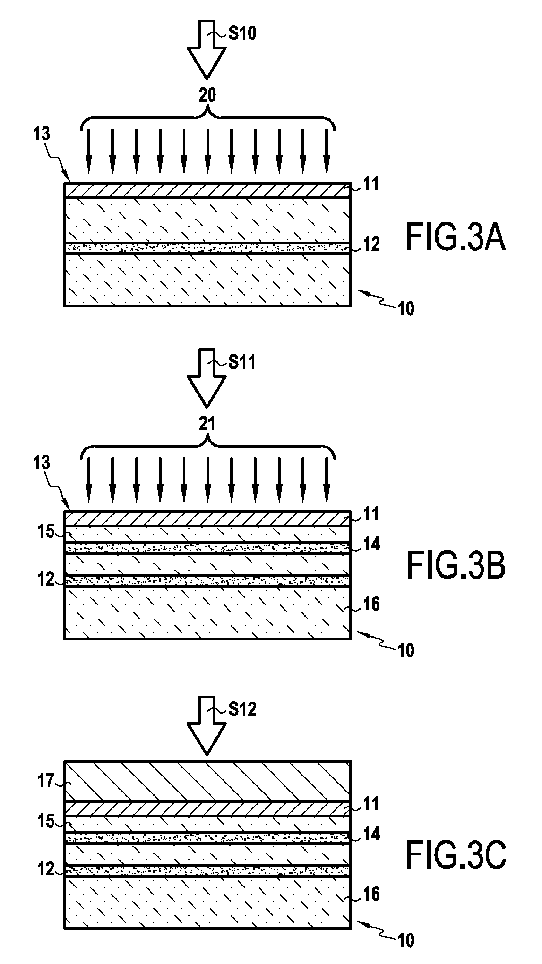

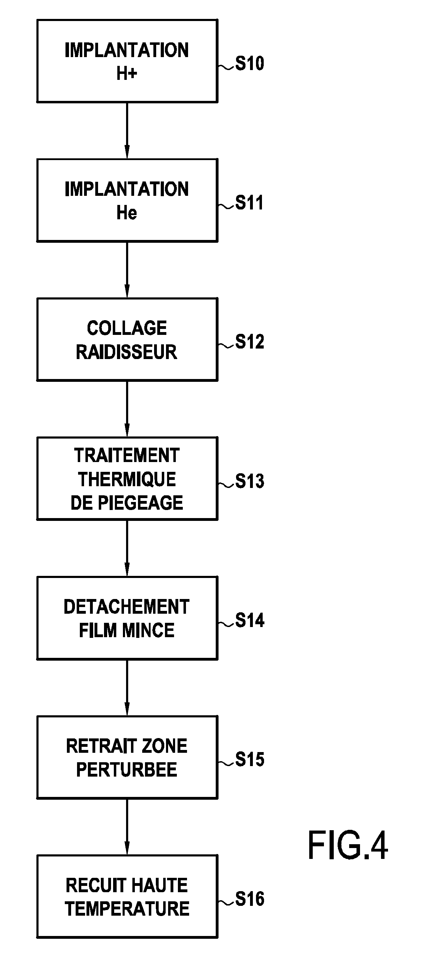

Les figures 3A à 3F et 4 illustrent une variante d'un procédé de réalisation d'un film mince conformément à l'invention. Cette mise en oeuvre diffère de celle décrite précédemment notamment en ce qu'il est formé deux couches de microcavités à des profondeurs différentes dans le substrat, une couche étant utilisée pour piéger les contaminants et l'autre pour permettre le détachement du film mince.

Le substrat de départ 10 est constitué d'une plaque (ou "wafer") de silicium monocristallin recouvert d'une couche d'oxyde de silicium (SiO₂ 11 obtenue par oxydation thermique et présentant une épaisseur d'environ 1450 Å.

Dans une première étape d'implantation (étape S10), le substrat 1 est tout d'abord soumis à un bombardement ionique 20 d'ions hélium He à travers la face plane 13 du substrat comportant la couche (SiO₂) 11. L'implantation des ions He est réalisée avec une énergie d'implantation d'environ 60 keV et une dose d'implantation d'environ 1,5.10¹⁶ atomes/cm². Ces conditions d'implantation permettent de créer, à une profondeur d'environ 300 nm dans le substrat 10, une couche de concentration d'ions He 12 (figure 3A).

Dans une deuxième étape d'implantation (étape S11), qui peut être postérieure ou antérieure à la première étape d'implantation d'ions He, le substrat 1 est soumis à un bombardement ionique 21 d'ions hydrogène H⁺ à travers la face plane 13. L'implantation des ions H⁺ est réalisée avec une énergie d'implantation d'environ 32 keV et une dose d'implantation d'environ 1,5.10¹⁶ atomes/cm². Ces conditions d'implantation permettent de créer, à une profondeur d'environ 230 nm dans le substrat 10, une couche de concentration d'ions H⁺ 14 délimitant, d'une part, un film mince 15 dans la région supérieure du substrat 10 et, d'autre part, une portion 16 dans la région inférieure du substrat correspondant au reste du substrat 10 (figure 3B).

Dans la première étape d'implantation (étape S10), l'énergie d'implantation est plus importante que dans la deuxième étape d'implantation (étape S11). Cela permet de créer une couche de concentration d'ions He 12 située plus profondément par rapport à la surface du substrat que la couche de concentration d'ions H⁺ 14 créée lors de la deuxième implantation.

Le substrat de départ 10 implanté est ensuite collé, par exemple par adhésion moléculaire, sur un raidisseur 17, par exemple une plaque de silicium (étape S12, figure 3C). Le substrat de départ 1 contient des impuretés résiduelles (comme du fluor F, du carbone C, etc.). En outre, les étapes d'oxydation (formation couche de SiO₂) d'implantation ionique et de collage peuvent augmenter en volume la contamination en impuretés du substrat de départ 10.

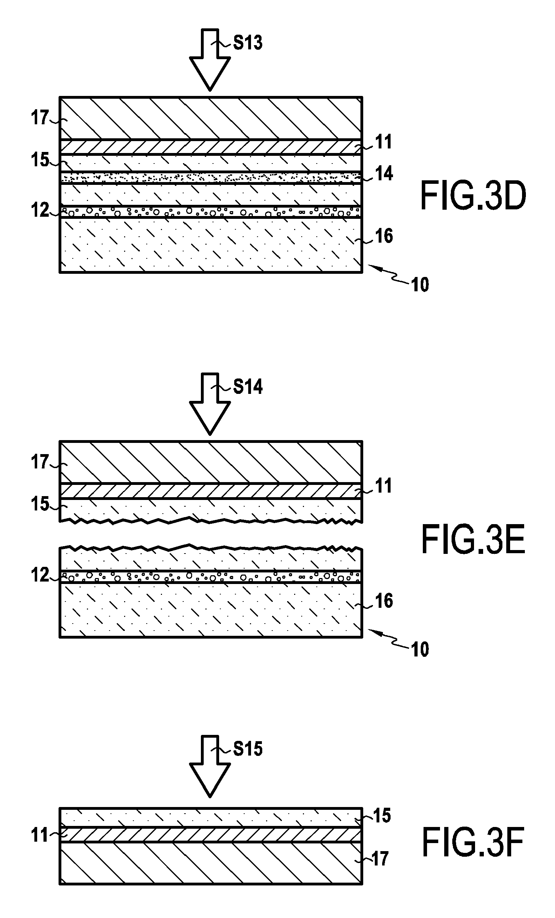

Conformément à l'invention, on procède à une étape de traitement thermique permettant le développement et/ou la formation de microcavités au niveau de la couche de concentration d'ions He 12 (i.e. à 300 nm sous la surface du substrat 10) ainsi que la diffusion et le piégeage des diverses espèces contaminantes dans ces microcavités (étape S13, figure 3D). Dans ce mode de réalisation, les microcavités au niveau de la couche 12 constituent seulement des pièges pour les espèces contaminantes diffusées.

L'étape de traitement thermique peut être, par exemple, un recuit à 400 °C pendant une heure permettant notamment d'augmenter localement la quantité en ions fluor et en impuretés carbone au niveau de la couche 12 et, par conséquent, de diminuer la concentration en ions fluor et en impuretés carbone dans le reste du substrat et en particulier dans la portion correspondant au film mince 15 à détacher. Une partie des impuretés est également piégée dans la couche de concentration d'ions H⁺ 14, mais dans une quantité moindre par rapport à la couche de concentration d'ions H⁺ 3 du mode de réalisation décrit en relation avec les figures 1A à 1E et 2.

Cette étape de traitement thermique peut être indifféremment réalisée avant ou après l'étape de collage du raidisseur.

On procède ensuite à un recuit à une température supérieure à la température de traitement thermique pour le piégeage des contaminants et qui est suffisante pour créer par effet de réarrangement cristallin dans le substrat et de pression dans les microcavités de la couche de concentration d'ions H⁺ 14 un clivage entre le film mince 15 et la portion 16 du reste du substrat 10 (étape S14, figure 3E). Un recuit à 500 °C pendant 30 minutes permet d'entraîner la fracture du substrat 10 au niveau de la couche de concentration d'ions H⁺ 14 située à environ 230 nm sous la surface du substrat 10.

Le film mince 15 transféré sur le raidisseur 17 présente une épaisseur d'environ 230 nm et contient peu de contaminants dans son volume comme en surface, une partie des contaminants étant confinée au niveau des microcavités de piégeage de la couche 12 qui n'a pas été transférée et qui subsiste dans la portion 16 du reste du substrat.

Une étape de polissage classique (polissage mécano-chimique) est alors réalisée pour éliminer la zone perturbée de la surface du film mince 15 et pour réduire son niveau de rugosité (étape S15, figure 3F). L'épaisseur retirée par le polissage est de l'ordre de 1500 Å. La zone perturbée peut être également éliminée par une attaque (gravure) chimique sélective éventuellement suivie d'un polissage pour améliorer la rugosité de surface.

Une étape de traitement thermique final à haute température (1100°C) (étape S16) peut être réalisée pour améliorer la qualité du film transféré.

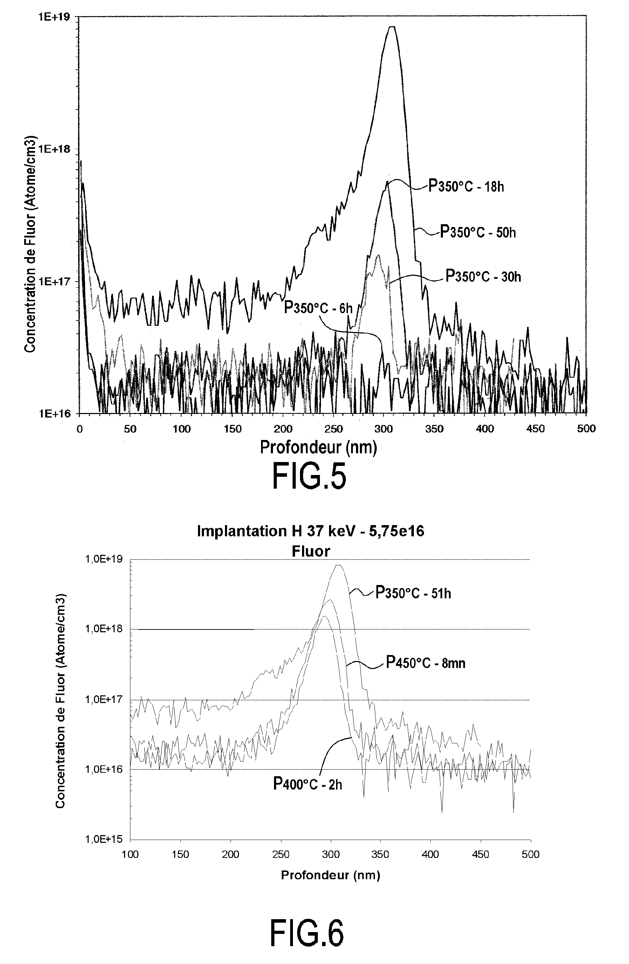

Des mesures ont été réalisées (figures 5 à 7) pour démontrer que, pour des conditions d'implantations compatibles avec une étape ultérieure de fracture au niveau de la zone implantée, un traitement thermique post-implantation permet de piéger les contaminants présents dans le substrat implanté.

Les figures 5 à 7 montrent les résultats de mesures en concentration de contaminants obtenus dans des substrats de silicium monocristallin implantés dans les conditions décrites en relation avec les figures 1A et 1B et les étapes S1 et S2 de la figure 2 (à savoir implantation d'espèces H⁺ dans le substrat Si avec une énergie d'implantation d'environ 37 keV et une dose d'implantation d'environ 5,75.10¹⁶ atomes/cm²). Les figures 5 à 7 montrent les résultats obtenus en fonction des conditions (durée et/ou température) de l'étape de traitement thermique selon l'invention (étape S3, figure 1C). Les mesures de concentration ont été réalisées par microanalyse par spectrométrie de masse d'ions secondaires (mesure SIMS, "Secondary Ion Mass Spectroscopy").

La figure 5 montre l'influence de la durée du traitement thermique selon l'invention sur le piégeage de contaminants dans le cas du fluor. Les quatre courbes de la figure 5 P_{350°C-50h,} P_{350°C-30h}, P_{350°C-18h} et P_{350°C-6h} correspondent à la concentration en fluor observée dans l'épaisseur du substrat Si implanté avec des ions hydrogène pour un traitement thermique réalisé à une température de 350 °C sur une durée respectivement de 50 heures, 30 heures, 18 heures et 6 heures. On observe que la concentration en fluor augmente significativement au environ d'une profondeur de 300 nm dans le substrat qui correspond à la zone implantée dans laquelle sont piégés les contaminants. L'augmentation de concentration en fluor dans la zone de piégeage (i.e. à environ 300 nm de profondeur dans le substrat) est plus importante lorsque le traitement thermique à 350 °C est réalisé sur une durée de 50 heures.

La figure 6 montre l'influence de la température du traitement thermique selon l'invention sur le piégeage de contaminants dans le cas du fluor. Les trois courbes de la figure 6 P₃₅₀₋₅₁ₕ, P₄₀₀₋₂ₕ et P_{450°C-8mn} correspondent à la concentration en fluor observée dans l'épaisseur du substrat Si implanté avec des ions hydrogène pour un traitement thermique réalisé respectivement à une température de 350 °C sur une durée de 51 heures, à une température de 400 °C sur une durée de 2 heures, et à une température de 450 °C sur une durée de 8 minutes. On observe que la concentration en fluor augmente significativement au environ d'une profondeur de 300 nm dans le substrat qui correspond à la zone implantée dans laquelle sont piégés les contaminants. L'augmentation de concentration en fluor dans la zone de piégeage (i.e. à environ 300 nm de profondeur dans le substrat) est plus importante lorsque le traitement thermique est réalisé à 350 °C sur une durée de 51 heures. Toutefois, on observe qu'un traitement thermique réalisé à des températures plus élevées (400 °C et 450 °C) mais sur des durées bien inférieures à 51 heures, à savoir 2 heures pour 400 °C et 8 minutes pour 450 °C, permettent également d'obtenir un piégeage efficace du fluor.

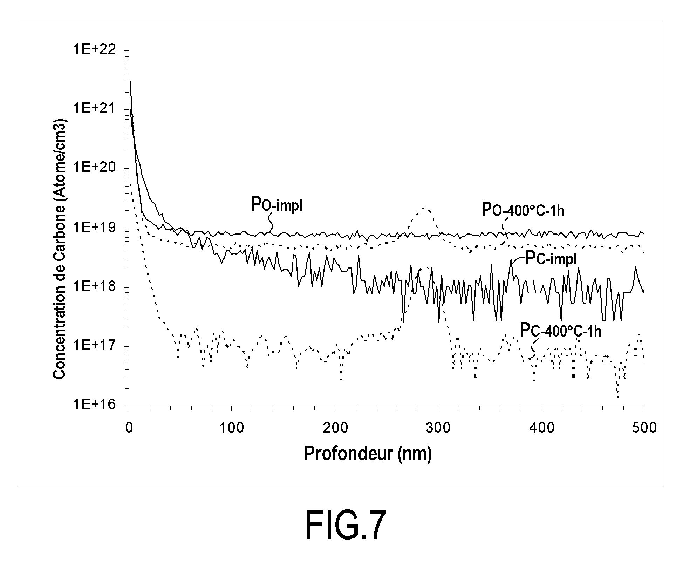

La figure 7 montre l'influence du traitement thermique post-implantation suivant la nature des contaminants, ici des contaminants de type contaminants organiques oxygène (O) et carbone (C). Les quatre courbes de la figure 7 P_{O-impl}, P_{O-400°C-1h}, P_{C-impl} et P_{C-400°C-1h} correspondent respectivement à:
- la concentration en impuretés oxygène observée dans l'épaisseur du substrat Si implanté avec des ions hydrogène sans traitement thermique,
- la concentration en impuretés oxygène observée dans l'épaisseur du substrat Si implanté avec des ions hydrogène soumis à un traitement thermique réalisé à une température de 400 °C sur une durée d'une heure,
- la concentration en impuretés carbone observée dans l'épaisseur du substrat Si implanté avec des ions hydrogène sans traitement thermique,
- la concentration en impuretés carbone observée dans l'épaisseur du substrat Si implanté avec des ions hydrogène soumis à un traitement thermique réalisé à une température de 400 °C sur une durée d'une heure.

On observe une diminution de la concentration en impuretés sur l'ensemble du substrat implanté (dans la limite de profondeur analysée) et notamment sur toute l'épaisseur du substrat (entre 0 et 300 nm) correspondant au film mince à transférer. Sur cette mesure, la concentration de l'impureté carbone diminue d'une décade dans le futur film mince à transférer.

## Revendications

1. Procédé de fabrication d'un film mince comprenant:
a) au moins une étape d'implantation par bombardement d'une face (7) d'un substrat en matériau semi-conducteur au moyen d'ions pour former, à une profondeur déterminée dans le substrat, une couche de concentration desdits ions implantés (3), ladite couche de concentration délimitant, dans la partie supérieure du substrat, un film mince (4),
b) une étape de mise en contact intime de la face (7) du substrat (1) avec un raidisseur (6),
c) une étape de détachement du film mince (4) en contact avec le raidisseur (6) par clivage au niveau de la couche de concentration des ions (3),
**caractérisé en ce qu'**il comprend en outre, après l'étape a) d'implantation et avant l'étape c) de détachement, une étape de traitement thermique de piégeage des contaminants qui ne provoque pas le clivage du substrat au niveau de la couche de concentration d'ions (3), et, après l'étape c), une étape de retrait de la zone perturbée par le piégeage des contaminants et par l'étape c) de détachement.

2. Procédé selon la revendication 1, **caractérisé en ce que**, dans l'étape a), les ions sont des ions de gaz hydrogène.

3. Procédé selon la revendication 1 ou 2, **caractérisé en ce que** le substrat (1) est un substrat de silicium, ou de germanium, ou de silicium-germanium, ou de nitrure de gallium, ou d'arséniure de gallium, ou de carbure de silicium.

4. Procédé selon l'une quelconque des revendications 1 à 3, **caractérisé en ce que** le substrat (1) est un substrat de silicium monocristallin et **en ce que** l'étape de traitement thermique de piégeage des contaminants est réalisée à une température comprise entre 350 °C et 450 °C.

5. Procédé selon la revendication 1 à 4, **caractérisé** l'étape de traitement thermique de piégeage des contaminants est réalisée à une température d'environ 350 °C pendant une durée comprise entre 18 et 30 heures environ.

6. Procédé selon l'une quelconque des revendications 1 à 3, **caractérisé en ce qu'**il comprend en outre une étape d'implantation supplémentaire consistant à bombarder la face (13) du substrat (10) au moyen d'ions dans des conditions différentes de celles utilisées pour l'implantation de l'étape a), ladite étape d'implantation supplémentaire étant au moins réalisée à une énergie d'implantation supérieure à celle de l'étape a) pour créer une couche de concentration d'ions (12) à une profondeur plus importante que la couche de concentration d'ions (14) crée lors de l'étape a).

7. Procédé selon la revendication 6, **caractérisé en ce que**, dans ladite étape d'implantation supplémentaire, les ions sont des ions de gaz hélium.

8. Procédé selon la revendication 7, **caractérisé en ce que** le substrat (10) est un substrat de silicium monocristallin et **en ce que** l'étape de traitement thermique de piégeage des contaminants est réalisée à une température d'environ 400 °C pendant une durée d'environ 1 heure.

9. Procédé selon l'une quelconque des revendications 1 à 8, **caractérisé en ce que**, dans l'étape c), une contrainte de détachement est appliquée au niveau de la couche de concentration des ions implantés (3; 14).

10. Procédé selon la revendication 9, **caractérisé en ce que** la contrainte de détachement consiste en une application d'un traitement thermique et/ou d'une contrainte mécanique de détachement et/ou d'efforts de traction et/ou de flexion et/ou de cisaillement et/ou d'ultrasons ou de micro-ondes.

11. Procédé selon !'une quelconque des revendications 1 à 8, **caractérisé en ce que**, dans l'étape c), un recuit est réalisé à une température supérieure à la température du traitement thermique de piégeage des contaminants pour provoquer le clivage au niveau de la couche de concentration d'ions (3; 14) formée lors de l'étape a).

12. Procédé selon l'une quelconque des revendications 1 à 11, **caractérisé en ce que** l'étape de retrait de la zone perturbée est réalisée par polissage mécano-chimique ou par attaque chimique sélective.

13. Procédé selon l'une quelconque des revendications 1 à 12, **caractérisé en ce qu'**il comprend en outre, après l'élimination de la zone perturbée au dessus du film mince transféré (4; 15), une étape de recuit à environ 1000°C dudit film sur le raidisseur.
